# EUROPÄISCHE PATENTANMELDUNG

(11) **EP 2 190 016 A1**
(43) Veröffentlichungstag der Anmeldung: **26.05.2010**
(21) Anmeldenummer: 09012246.6
(22) Anmeldetag: 26.09.2009
(51) Int. Cl.: H01L 25/16, H01L 23/498, H01F 17/00, H01F 27/28, H01L 23/64, H01L 25/07

(54) **Leistungshalbleitermodul mit Steuerfunktionalität und integriertem Übertrager**

(30) Priorität: 19.11.2008 DE 102008057833
(71) Anmelder: SEMIKRON Elektronik GmbH & Co. KG, 90431 Nürnberg (DE)
(72) Erfinder: Beckedahl, Peter, 90522 Oberasbach (DE); Herzer, Reinhard, Dr., 98693 Ilmenau (DE); Stockmeier, Thomas, Dr., 91054 Erlangen (DE)

(57) **Zusammenfassung**

Die Erfindung beschreibt ein Leistungshalbleitermodul mit einem Substrat (2), einer hierauf angeordneten Mehrzahl gegeneinander elektrisch isolierten Leiterbahnen und mit hierauf angeordneten Leistungshalbleiterbauelementen (4), mit einer Verbindungseinrichtung (6), bestehend aus einer alternierenden Schichtfolge mindestens zweier elektrisch leitender Schichten (60,62,64a/b) und mindestens einer elektrisch isolierenden Schicht (61,63), zur schaltungsgerechten Verbindung der Leistungshalbleiterbauelemente (4), der Leiterbahnen und / oder externer Kontakteinrichtungen (10). Die elektrisch leitenden Schichten (60,62,64a/b) bilden Verbindungsbahnen aus und wobei mindestens ein Übertrager (70) angeordnet ist, der integral und somit aus den Bestandteilen der Verbindungseinrichtung (6) gebildet ist. Der Übertrager (70) besteht aus mindestens einer Sender (76)- und mindestens einer Empfängerspule (72,74), die jeweils koaxial zueinander angeordnet sind und mit spiralförmigen Wicklungen ausgebildet sind.

## Beschreibung

Die Erfindung beschreibt ein Leistungshalbleitermodul mit Steuerfunktionaliät, wobei nicht nur Leistungshalbleiterbauelemente, sondern auch Teile einer zugehörigen Treiberschaltung Bestandteile des Leistungshalbleitermoduls sind. Die gesamte Treiberschaltung eines Leistungshalbleitermoduls, zumindest für höhere Spannungen jenseits von 100V, weisen meist zwei potentialgetrennte Schaltungsteile, eine Primär- und eine Sekundärseite, auf. Für die Signalübertragung oder auch die Spannungsversorgung zwischen diesen Schaltungsteilen werden häufig Übertrager eingesetzt. Typischerweise sind derartige Übertrager analog einen Transformator mit zwei Spulen und einem diese verbindenden Kern aufgebaut.

Ebenso bekannt sind aus der DE 101 00 282 A1 allerdings auch Transformatoren zur Anordnung auf Halbleiterkörpern ohne den die beiden Spulen verbindenden Kern. Derartige Transformatoren weisen somit allerdings auch einen geringeren Wirkungsgrad auf.

Weiterhin sind beispielhaft aus der DE 103 55 925 A1 Verbindungseinrichtungen aus einer alternierenden Folge von leitenden und isolierenden Schichten zur schaltungsgerechten Verbindung der Schaltungsanordnung eines Leistungshalbleitermoduls bekannt. Hierbei werden die leitenden Schichten strukturiert und bilden somit voneinander elektrisch isolierte Verbindungsbahnen aus. Derartige Verbindungseinrichtungen sind besonders bevorzugt für kompakte Aufbauten von Leistungshalbleitermodulen. Auch ist es bereits bekannt auf derartigen Verbindungseinrichtungen Steuerbausteine und für deren Funktion notwendige Widerstände und Kondensatoren auf einer leitenden Schicht anzuordnen.

Ebenso bekannt, beispielhaft aus der DE 10 2006 021 412 A1, ist die Integration von Steuerfunktionalität in einem Leistungshalbleitermodul. Hierbei werden auf einem üblicherweise für die Anordnung der Leistungshalbleiterbauelemente vorgesehenen Substrat mit dortigen Leiterbahnen Steuerbausteine und falls notwendig weitere Bauelemente, wie Widerstände und Kondensatoren angeordnet und mittels der Leiterbahnen schaltungsgerecht verbunden. Weitere Bauelemente vor allem diejenigen mit im Vergleich zu den Leistungshalbleiterbauelement größeren Dimensionen werden üblicherweise allerdings außerhalb des Leistungshalbleitermoduls angeordnet.

Der Erfindung liegt die Aufgabe zugrunde ein Leistungshalbleitermodul anzugeben, bei dem weitere Steuerfunktionalität integriert ist.

Diese Aufgabe wird erfindungsgemäß gelöst, durch ein Leistungshalbleitermodul mit den Merkmalen des Anspruchs 1. Bevorzugte Ausführungsformen sind in den abhängigen Ansprüchen beschrieben.

Ausgangspunkt der Erfindung ist ein Leistungshalbleitermodul mit einem Substrat, einer hierauf angeordneten Mehrzahl gegeneinander elektrisch isolierten Leiterbahnen und mit hierauf angeordneten Leistungshalbleiterbauelementen. Diese sind mit der jeweiligen zugeordneten Leiterbahn des Substrats elektrisch leitend verbunden.

Zur weiteren schaltungsgerechten Verbindung von Leistungshalbleiterbauelementen, Leiterbahnen und / oder externen Kontakteinrichtungen weist das Leistungshalbleitermodul eine Verbindungseinrichtung auf. Als Verbindungseinrichtung dient hierbei eine alternierende Schichtfolge mindestens zweier elektrisch leitender Schichten und mindestens einer dazwischen angeordneten elektrisch isolierenden Schicht. Hierzu sind die elektrisch leitenden Schichten in sich strukturiert und bilden elektrisch voneinander isolierte Verbindungsbahnen aus.

Das Leistungshalbleitermodul weist weiterhin Steuerfunktionalität auf mittels derer durch extern anliegende Signale die Leistungshalbleiterbauelemente des Leistungshalbleitermoduls angesteuert werden. Hierzu sind auf mindestens einer elektrisch leitenden Schicht der Verbindungseinrichtung Steuerbausteine und vorzugsweise auch weitere Bauelemente wie Widerstände und Kondensatoren angeordnet. Dieser mindestens eine Steuerbaustein und die weiteren Bauelemente sind mittels der Verbindungsbahnen elektrisch kontaktiert.

Erfindungsgemäß weist das Leistungshalbleitermodul mindestens einen integral aus der Verbindungseinrichtung gebildeten Übertrager auf, der mit einem Steuerbaustein mittels Verbindungsbahnen elektrisch leitend verbunden ist. Dieser mindestens eine Übertrager ist integral aus den Bestandteilen der Verbindungseinrichtung ausgebildet. Speziell werden die Wicklungen des Übertragers aus Verbindungsbahnen der Verbindungseinrichtung gebildet. Es ist bevorzugt, wenn der Übertrager aus mindestens einer Sender- und mindestens einer Empfängerspule besteht, die jeweils spiralförmig ausgebildet und koaxial zueinander angeordnet sind. Grundsätzlich kann mehr als eine Wicklung von den Verbindungsbahnen einer elektrisch leitenden Schicht der Verbindungseinrichtung ausgebildet sein. Vorzugsweise liegen die Wicklungen eines Übertragers allerdings auf verschiedenen elektrisch leitenden Schichten der Verbindungseinrichtung.

Besonders bevorzugte Weiterbildungen dieses Leistungshalbleitermoduls sind in der jeweiligen Beschreibung der Ausführungsbeispiele genannt. Die erfinderische Lösung wird zudem an Hand der Ausführungsbeispiele der Fig. 1 bis 4 weiter erläutert.

Fig. 1 zeigt einen stark schematisierten Schnitt durch ein erfindungsgemäßes Leistungshalbleitermodul.

Fig. 2 zeigt sowohl in Draufsicht wie auch im Schnitt einen Ausschnitt einer ersten erfindungsgemäßen Ausgestaltung eines Leistungshalbleitermoduls.

Fig. 3 zeigt schematisch einen Ausschnitt einer zweiten erfindungsgemäßen Ausgestaltung eines Leistungshalbleitermoduls im Schnitt.

Fig. 4 zeigt schematisch sowohl in Draufsicht wie auch im Schnitt einen Ausschnitt einer dritten erfindungsgemäßen Ausgestaltung eines Leistungshalbleitermoduls.

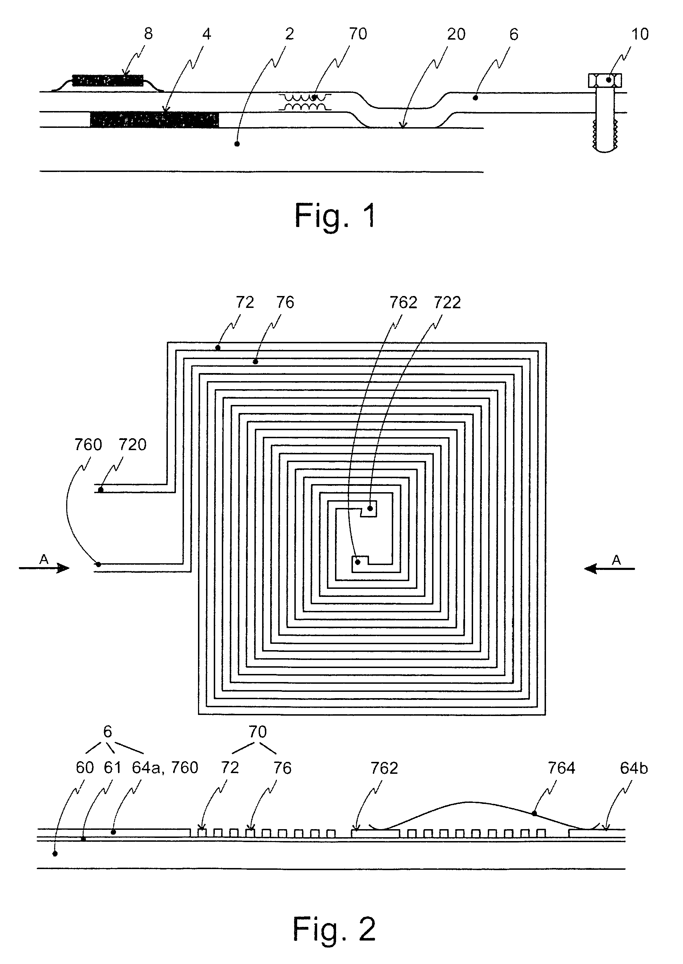

Fig. 1 zeigt einen stark schematisierten Schnitt durch ein erfindungsgemäßes Leistungshalbleitermodul mit einer Verbindungseinrichtung (6). Dargestellt ist hierbei ein Substrat (2), wie es als sog. DCB- (direct copper bonding) oder IMS- (integrated metal substrate) Substrat bekannt und häufig eingesetzt ist, ohne dass dies eine Beschränkung auf derartige Substrate bedeuten soll. Dieses Substrat (2) weist eine isolierende Lage mit darauf angeordneten Leiterbahnen auf. Eine dieser Leiterbahnen trägt hier ein ungehaustes Halbleiterbauelement (4), beispielsweise einen Leistungstransistor, wie er häufig zur Ansteuerung von Drehstrommotoren eingesetzt wird.

Zur elektrisch leitenden Verbindung zwischen der das Halbleiterbauelement (4) tragenden Leiterbahn und einer Kontaktfläche auf der ersten Hauptfläche des Halbleiterbauelements (4) ist bevorzugt eine Sintermetallschicht angeordnet. Diese Sintermetallschicht entsteht während des Sinterprozesses der Herstellung aus eine Suspension aus einem Lösungsmittel und Edelmetallflocken und stellt anschließend eine elektrisch leitende Verbindung hoher Zuverlässigkeit dar.

Die zweite Hauptfläche des Halbleiterbauelements (4), hier des Leistungstransistors, weist zwei Kontaktflächen auf, die der elektrisch leitenden Verbindung mit der Verbindungseinrichtung (6) dienen, wobei auch diese Verbindungen vorzugsweise als Sinterverbindungen ausgebildet sind. Ebenso weist die Verbindungseinrichtung (6) Kontaktflächen (20) mit Leiterbahnen des Substrats (2) auf.

Die Verbindungseinrichtung (6) selbst weist hier einen alternierenden Aufbau aus drei Schichten (vgl. Fig. 2) auf, wobei die Schichtfolge vom Substrat aus betrachtet mit einer ersten elektrisch leitenden Schicht beginnt, auf die eine erste isolierende und dann wieder eine zweite leitende Schicht folgt. Die erste leitende Schicht dient hauptsächlich der Lastverbindung der Leistungshalbleiterbauelement (4), während die zweite, hier dünner ausgestaltete leitende Schicht der Führung der Steuersignale dient.

Diese Steuersignale werden, wie auch die Lastströme mittels einer externen Kontakteinrichtung (10), hier schematisch als Schraubverbindung ausgebildet, in die Verbindungseinrichtung (6) eingespeist. Hierbei werden nicht vollständig aufbereitete Steuersignale eingespeist, sondern nur grundlegende Steuerbefehle, die mittels der Steuerfunktionalität, die erfindungsgemäß integraler Bestandteil des Leistungshalbleitermoduls ist, in entsprechende Steuersignale umgewandelt werden. Hierzu sind auf der zweiten leitenden Schicht Steuerbausteine (8) sowie, nicht dargestellt, weitere Bauelemente, wie Widerstände und Kondensatoren angeordnet. Zu potentialgetrennten Pegelumsetzung ist weiterhin in die Verbindungseinrichtung (6) selbst ein Übertrager (70) integriert.

Fig. 2 zeigt sowohl in Draufsicht wie auch im Schnitt einen Ausschnitt einer ersten erfindungsgemäßen Ausgestaltung eines Leistungshalbleitermoduls. Dargestellt ist hier ausschließlich ein Teil der Verbindungseinrichtung (6) mit einem hierin integrierten Übertrager (70). Dieser Übertrager (70) weist je eine Sender- (76) und eine Empfängerspule (72) auf, die zueinander koaxial angeordnet sind. Da die jeweiligen Wicklungen der Sender- (76) und Empfängerspule (72) in einer Ebene liegen sind diese als quadratische Spiralen ausgebildet mit jeweils einer ersten Kontaktstelle (720, 760) am äußeren Beginn der Spirale und jeweils einer zweiten Kontaktstelle (722, 762) im Inneren der Spirale.

Die Wicklungen der Sender- (76) und Empfängerspule (72) sind aus Verbindungsbahnen (64a) ausgebildet und somit in einem Arbeitsgang mit den übrigen Verbindungsbahnen (60, 64) der Verbindungseinrichtung (6), also auch den Zuleitungen zur jeweils ersten Kontaktstelle (720, 760) der jeweiligen Spule, herzustellen. Zur Verbindung der zweiten Kontaktstellen (722, 762) mit jeweils weiteren Verbindungsbahn (64b) sind hier Bond-, vorzugsweise Drahtbondverbindungen (764) vorgesehenen.

In dieser Ausbildung des Übertragers (70) sind die Wicklungen der jeweiligen Spulen (72, 76) auf der gleichen, hier der zweiten, elektrisch leitenden Schicht (64) der Verbindungseinrichtung (6) angeordnet und derart ineinander verschachtelt, dass die spiralförmigen Verbindungsbahnen (76) der Senderspule sich in ihrer lateralen Lage parallel zur Oberfläche der Verbindungseinrichtung (6) mit denen der Empfängerspule (72) abwechseln. Die elektrische Isolierung der beiden Spulen (72, 76) gegeneinander wird durch die Beabstandung der ihre Wicklungen bildenden Verbindungsbahnen erreicht.

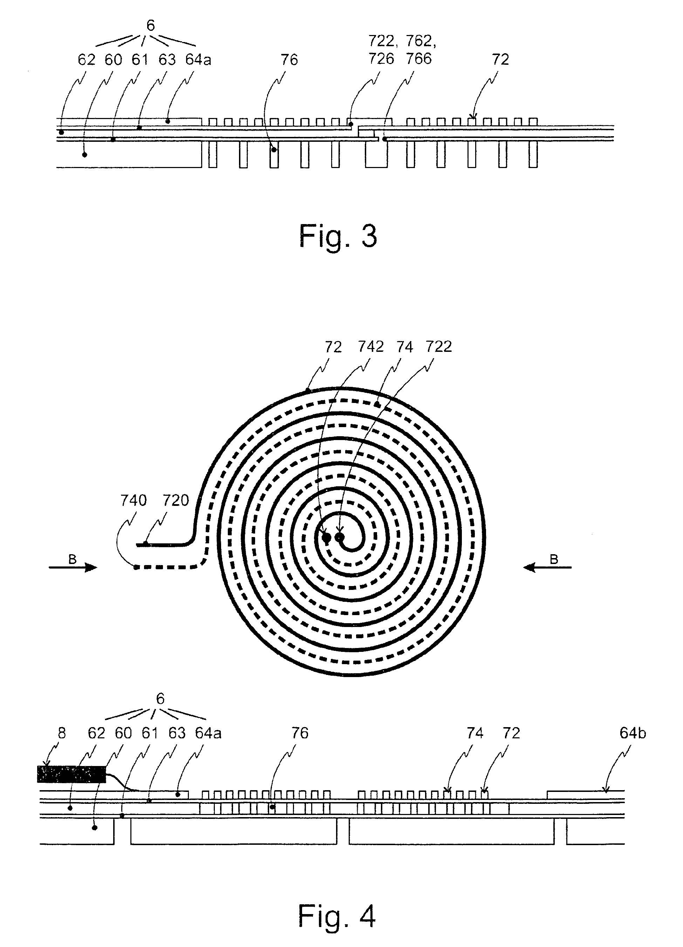

Fig. 3 zeigt schematisch einen Ausschnitt einer zweiten erfindungsgemäßen Ausgestaltung eines Leistungshalbleitermoduls im Schnitt. Dargestellt ist hier wiederum nur ein Teil der Verbindungseinrichtung (6) mit dem hierin integrierten Übertrager (70). Dieser Übertrager (70) weist je eine Sender- (76) und eine Empfängerspule (72) auf, die zueinander koaxial angeordnet sind. Allerdings liegen die jeweiligen kreisspiralförmigen Wicklungen der Sender- (76) und Empfängerspule (72) in unterschiedlichen Ebenen auf unterschiedlichen elektrisch leitenden Schichten (60, 64) der Verbindungseinrichtung (6). In dieser Ausgestaltung weist die Sender- (76) und die Empfängerspule (72) im Gegensatz zur Darstellung gemäß Fig. 2 zudem eine unterschiedliche Anzahl von Wicklungen auf.

Die elektrische Isolierung der beiden Spulen (72, 76) gegeneinander wird hier durch die isolierenden Schichten (61, 63) der Verbindungseinrichtung (6) erreicht. Der weitere grundsätzliche Aufbau der jeweiligen Wicklungen aus den Verbindungsbahnen ist identische demjenigen gemäß Fig. 2.

Zur Verbindung der jeweiligen zweiten Kontakteinrichtungen (722, 762) der Spulen (72, 76) weist die Verbindungseinrichtung (6) eine weitere elektrisch leitende Schicht (62) auf, deren Verbindungsbahnen die Zuleitungen zu der jeweiligen zweiten Kontaktstellen (722, 762) ausbilden. Hierzu ist diese weitere leitende Schicht (62) zwischen den beiden übrigen leitenden Schichten (60, 64) angeordnet und jeweils durch eine isolierende Schicht (61, 63) von dieser getrennt. Jede der isolierenden Schichten (61, 63) weist weiterhin je eine Durchkontaktierung (726, 766) zur elektrisch leitenden Verbindung der jeweiligen zweiten Kontaktstelle (722, 762) mit der jeweils zugeordneten Verbindungsbahn (62) der weiteren leitend Schicht (62) auf.

Fig. 4 zeigt schematisch sowohl in Draufsicht wie auch im Schnitt einen Ausschnitt einer dritten erfindungsgemäßen Ausgestaltung eines Leistungshalbleitermoduls. Dargestellt ist hier ebenfalls ausschließlich ein Teil der Verbindungseinrichtung (6), hier wiederum ausgebildet mit drei elektrisch leitenden Schichten (60, 62, 64) und zwei jeweils dazwischen angeordneten isolierenden Schichten (61, 63). Die zweite (64) und weitere (62) elektrisch leitende Schicht dienen jeweils der Führung der Steuersignale, wobei in dieser Ausgestaltung auch der Übertrager (70), der eine Senderspule (76) und zwei Empfängerspulen (72, 74) aufweist, aus diesen beiden Schichten ausgebildet ist.

Da hier drei Spulen (72, 74, 76) des Übertragers (70) anzuordnen sind, sind die Senderspule (76) auf der weiteren elektrisch leitenden Schicht (62) und die beiden Empfängerspulen (72, 74) auf der zweiten elektrisch leitenden Schicht (64) angeordnet. Die beiden Empfängerspulen (72, 74) sind in analoger Weise wie die beiden Spulen in Fig. 2 ineinander verschachtelt angeordnet, wodurch alle drei Spulen (72, 74, 76) koaxial zueinander angeordnet sind.

Bei dieser Ausführung ist es ebenso bevorzugt, wenn die zweiten Kontaktstellen einer jeden Sender- (76) oder Empfängerspule (72, 74) mittels einer Durchkontaktierungen durch mindestens eine isolierende Schicht (61, 63) mit einer Leiterbahn einer direkt oder indirekt benachbarten elektrisch leitenden Schicht verbunden sind. Hierzu bietet sich die erste elektrisch leitende Schicht (60) an, auf der üblicherweise Lastströme geführt werden. Bei der Nutzung der ersten elektrisch leitenden Schicht (60) kann, ohne dass dies explizit dargestellt ist, die zweite Kontaktstelle auf einfache Weise und mittels weiterer Durchkontaktierungen schaltungsgerecht mit einer zugeordneten Verbindungsbahn auf der zweiten (64) oder weiteren (62) elektrisch leitenden Schicht verbunden werden.

Weiterhin dargestellt ist die direkte Verbindung einer der beiden Empfängerspulen (72) mit einem Steuerbaustein (8). Sowohl die Spulen, als auch die Verbindungsbahnen, sowohl diejenigen welche der Verbindung zum Steuerbaustein (8) dienen, wie auch alle weiteren dieser elektrisch leitenden Schicht sind grundsätzlich technisch identisch hergestellt und ausgebildet ist.

## Patentansprüche

1. Leistungshalbleitermodul mit einem Substrat (2), einer hierauf angeordneten Mehrzahl gegeneinander elektrisch isolierten Leiterbahnen und mit hierauf angeordneten Leistungshalbleiterbauelementen (4), mit einer Verbindungseinrichtung (6), bestehend aus einer alternierenden Schichtfolge mindestens zweier elektrisch leitender Schichten (60, 62, 64 a/b) und mindestens einer elektrisch isolierenden Schicht (61, 63), zur schaltungsgerechten Verbindung der Leistungshalbleiterbauelemente (4), der Leiterbahnen und / oder externer Kontakteinrichtungen (10),
wobei die elektrisch leitenden Schichten (60, 62, 64 a/b) Verbindungsbahnen ausbilden und wobei mindestens ein Übertrager (70) angeordnet ist, der integral und somit aus den Bestandteilen der Verbindungseinrichtung (6) gebildet ist.

2. Leistungshalbleitermodul nach Anspruch 1,
wobei der Übertrager (70) aus mindestens einer Sender- (76) und mindestens einer Empfängerspule (72, 74) besteht, die jeweils koaxial zueinander angeordnet, mit spiralförmigen Wicklungen ausgebildet sind sowie jeweils eine erste (720, 760) und eine zweite (722, 762) Kontaktstelle aufweisen.

3. Leistungshalbleitermodul nach Anspruch 2,
wobei die jeweiligen Wicklungen der Sender- (76) und Empfängerspule (72, 74) aus Verbindungsbahnen (60, 62, 64 a/b) der Verbindungseinrichtung (6) bestehen.

4. Leistungshalbleitermodul nach Anspruch 3,
wobei eine Sender- (76) und eine Empfängerspule (72) auf der gleichen elektrisch leitenden Schicht und ineinander verschachtelt angeordnet sind und hierbei die beiden Wicklungen durch Beabstandung der sie bildenden Verbindungsbahnen (64) gegeneinander elektrisch isoliert sind.

5. Leistungshalbleitermodul nach Anspruch 3,
wobei eine Sender- (76) und mindestens eine Empfängerspule (72, 74) auf zwei direkt oder indirekt benachbarten elektrisch leitenden Schichten (60, 62, 64 a/b) angeordnet sind und durch mindestens eine isolierende Schicht (61, 63) gegeneinander elektrisch isoliert sind.

6. Leistungshalbleitermodul nach Anspruch 3,
wobei eine Senderspule (76) auf einer elektrisch leitenden Schicht (62) und zwei Empfängerspulen (72, 74) auf einer weiteren elektrisch leitenden Schicht (64) angeordnet sind und diese Empfänderspulen (72, 74) dort ineinander verschachtelt sind.

7. Leistungshalbleitermodul nach Anspruch 2,
wobei die erste Kontaktstelle (720, 760) einer Sender- (76) oder Empfängerspule (72) direkt und einstückig ausgebildet mit einer die Zuleitung der Spule bildenden Verbindungsbahn (60, 62, 64 a/b) verbunden ist.

8. Leistungshalbleitermodul nach Anspruch 2,
wobei die zweite Kontaktstelle (722, 762) einer Sender- (76) oder Empfängerspule (72, 74) mittels einer Bondverbindung (764) mit einer weiteren Leiterbahn (64b) der gleichen elektrisch leitenden Schicht oder mittels einer Durchkontaktierung (726, 766) durch mindestens eine isolierende Schicht (61, 63) mit einer Leiterbahn einer weiteren elektrisch leitenden Schicht (62) verbunden ist.

9. Leistungshalbleitermodul nach Anspruch 1,
wobei auf mindestens einer elektrisch leitenden Schicht (60, 62, 64 a/b) mindestens ein Steuerbaustein (8) angeordnet und mit dortigen Verbindungsbahnen und mit mindestens einem Übertrager (70) verbunden ist.
